**Europäisches Patentamt**

(19) **European Patent Office**

**Office européen des brevets**

(11) Publication number : **0 342 038 B1**

# (12) EUROPEAN PATENT SPECIFICATION

(45) Date of publication of patent specification :
**05.07.95 Bulletin 95/27**

(51) Int. Cl.$^6$ : **H01L 39/24, H01L 39/22**

(21) Application number : **89304790.2**

(22) Date of filing : **11.05.89**

(54) Josephson device.

(30) Priority : **11.05.88 JP 112647/88**
**09.02.89 JP 28568/89**

(43) Date of publication of application :
**15.11.89 Bulletin 89/46**

(45) Publication of the grant of the patent :
**05.07.95 Bulletin 95/27**

(84) Designated Contracting States :
**CH DE FR GB LI NL**

(56) References cited :
**EP-A- 0 329 507**
**APPLIED PHYSICS LETTERS, vol. 39, no. 3, 1st**
**August 1981, pp. 280-282, American Institute**
**of Physics, New York, US; H. KROGER et al.:**
**"Selective niobium anodization process for**
**fabricating Josephson tunnel junctions"**
**JAPANESE JOURNAL OF APPLIED PHYSICS**
**2/ LETTERS, vol. 27, no. 4, 1988, pp. L661-L664,**
**Tokyo, JP ; A. MAEDA et al. : "Physical proper-**
**ties of an 80 K-superconductor : Bi-Sr-Ca-Cu-O**
**ceramics"**
**PROCEEDINGS OF THE FIRST LATIN-AMERI-**
**CAN CONFERENCE ON HIGH TEM-**
**PERATURESUPERCONDUCTIVITY, 4th-6th**
**May 1988, Rio de Janeiro, pp.194-201 ; R.**
**ESCUDERO et al.: "Electron tunneling in**
**ceramic superconductors"**

(56) References cited :
**PHYSICA C/SUPERCONDUCTIVITY, vol.**
**153-155, part I, 1988, pp. 896-897, Elsevier**
**Science Publishers B.V., Amsterdam, NL, &**
**ICHTSMMS, 28th February-4th March 1988, In-**
**terlaken ; L.H. GREENE et al.: "Tunneling**
**attempts in single-phase**
**Bi4Sr3Ca3Cu4O16+y and chemical doping on**
**the Cu-sites in 90 and 40K superconductors"**
**JOURNAL OF PHYSICS D: Applied Physics,**
**Vol. 20, No. 10, 14 October 1987, pp. 1330-1335**

(73) Proprietor : **CANON KABUSHIKI KAISHA**
**30-2, 3-chome, Shimomaruko,**
**Ohta-ku**
**Tokyo (JP)**

(72) Inventor : **Tanaka, Atsuko**
**12-8, Minami Naruse 3-chome**
**Machida-shi Tokyo (JP)**
Inventor : **Yamamoto, Keisuke**
**Canon Daiichi Honatsugiryo**
**6-29, Mizuhiki 2-chome**
**Atsugi-shi Kanagawa-ken (JP)**
Inventor : **Kawasaki, Takehiko**
**Canon Daiichi Honatsugiryo**
**6-29, Mizuhiki 2-chome**
**Atsugi-shi Kanagawa-ken (JP)**
Inventor : **Kaneko, Norio**
**19-5, Morinosato 3-chome**
**Atsugi-shi Kanagawa-ken (JP)**
Inventor : **Niizuma, Kiyozumi**
**Canon Daiichi Honatsugiyo**
**6-29, Mizuki 2 chome**
**Atsugi-shi Kanagawa-ken (JP)**

(74) Representative : **Beresford, Keith Denis Lewis**
**et al**
**BERESFORD & Co.**
**2-5 Warwick Court**
**High Holborn**
**London WC1R 5DJ (GB)**

## Description

The present invention relates to a Josephson device using a bismuth-based oxide superconductor and which is capable of being operated at a relatively high temperature.

A Josephson junction is formed of two superconductive layers separated by a very thin insulating layer and has been proposed for use as a high-speed switching device for use e.g. in computers because of the tunneling effect which is produced at the junction region.

A typical method for forming a Josephson junction involves forming a lead thin film followed by formation of a very thin oxide film on the surface of the lead thin film, the oxide film typically having a thickness of 30Å, after which another lead thin film is deposited thereon (see "CHODENDO (Superconduction)" edited by Japan Physics Society, p.147).

Several measurements have been reported concerning the Josephson effect in oxide superconductors having a high superconductive transition temperature. Superconductors having a high superconductive transition temperature have mainly been of the point contact type, but such junctions cannot provide devices that can be put into practical use e.g. in highly integrated circuits.

Amongst the devices in which an oxide superconductor is used, sandwich-type junctions based on lead have the disadvantage that it is difficult to form an insulating layer of thin and uniform thickness. Devices in which the insulating layer is of non-uniform thickness do not exhibit good characteristics and suffer from the disadvantage that the crystallizability of the superconductive layer may be significantly worsened if the insulating layer is of a material having a different crystal structure from the superconductor, again resulting in poor device characteristics.

The present invention provides a Josephson device having the features set out in claim 1.

Forms of this Josephson device do not suffer from the problems of non-uniformity and crystal structure of the superconductive layer, and provide a Josephson device having superior characteristics. The bismuth-based superconductor present in the above Josephson devices is less subject to atmospheric deterioration and contributes to the improved characteristics of the device.

A paper by H. Kroger et al, Applied Physics Letters, Vol. 39, No. 3, 1 August 1981 pages 280-282 discloses a Josephson device comprising a substrate having a lower superconductive layer, a tunneling layer and an upper superconductive layer laminated on it. However, the superconductive layers are of niobium based material, whereas the layers in the present Josephson device are of bismuth based materials.

A paper by M. G. Blamire, Journal of Physics D: Applied Physics, Vol. 20, No. 10, 14 October 1987 at pages 1330-1335 discloses a Josephson device formed by lower and upper superconductive layers made of $YBa_2Cu_3O_{7-x}$ and a tunneling layer made of $Y_2O_3$.

In a preferred embodiment, the present invention provides a Josephson device comprising a substrate, a lower superconductive layer, a tunneling layer and an upper superconductive layer which are laminated in this order, wherein:

the lower and upper superconductive layers each comprise a bismuth-copper-containing oxide superconductor represented by the formula:

$$\{(Bi_{1-b}C_b)_2O_2\}(Cu_{1-a}B_a)_{2+n}A_{3+n}O_{(12+3n)-x}$$

wherein A represents at least one element selected from the elemental group consisting of Group Ia, IIa, IIIa and IVb elements of the periodic table; B represents at least one element selected from the elemental group consisting of Group Ib, IVa, Va, VIa and VIIIa elements; C represents at least one element selected from rare earth elements; and $O \leqq b < 1$, $O \leqq a < 1$, $-1 < n \leqq 10$, and $x > 0$; and

the tunneling layer comprises a bismuth-containing oxide represented by the formula:

$$\{(Bi_{1-b}C_b)_2O_2\}^{2+}\{Bi_{1-a}B_a)_2(Ti_{1-a}A_a)_3O_{10}\}_n{}^{2-}$$

wherein C represents at least one element selected from rare earth elements; B represents at least one element selected from the group consisting of Ca, Na, K, Ba, Sr, Pb and Pr; A represents at least one element selected from the group consisting of Nb, Ta, Fe, Sn and Ga; and $O \leqq b < 1$, $O \leqq a < 1$, and $1 \leqq n \leqq 5$.

In another embodiment, the present invention also provides a Josephson device, comprising a substrate, a lower superconductive layer, a tunneling layer and an upper superconductive layer which are laminated in this order, wherein;

the lower and upper superconductive layers each comprise a bismuth-copper-containing oxide superconductor represented by the formula:

$$\{(Bi_{1-b}C_b)_2O_2\}(Cu_{1-a}B_a)_{2+n}A_{3+n}O_{(12+3n)-x}$$

wherein A represents at least one element selected from the elemental group consisting of Group Ia, IIa, IIIa and IVb elements of the periodic table; B represents at least one element selected from the elemental group consisting of Group Ib, IVa, Va, VIa and VIIIa elements; C represents at least one element selected from rare earth elements; and $O \leqq b < 1$, $O \leqq a < 1$, $-1 < n \leqq 10$, and $x > 0$; and

the tunneling layer comprises a bismuth-containing oxide represented by the formula:

$$Bi_2Sr_2LnCu_2O_y$$

wherein Ln represents at least one element selected from the group consisting of Y and lanthanides; and $7 \leqq y \leqq 9$.

## BRIEF DESCRIPTION OF THE DRAWINGS

Fig. 1 illustrates an example of the Josephson device of the present invention;

Fig. 2 illustrates a state wherein a bismuth-copper-containing oxide superconductor film is formed on a substrate;

Fig. 3 illustrates a state wherein a $Bi_4Ti_3O_{12}$ film is formed on the bismuth-copper-containing oxide superconductor film;

Fig. 4 illustrates a state wherein another bismuth-copper-containing oxide superconductor film is further formed on the $Bi_4Ti_3O_{12}$ insulating film;

Fig. 5 illustrates a state wherein a part of the laminated films is removed to form an electrode; and

Fig. 6 diagramatically shows current-voltage characteristics of a Josephson device obtained by the present invention.

## DETAILED DESCRIPTION OF THE PREFERRED EMBODIMENTS

In a Josephson device comprising a substrate, a lower superconductive layer, a tunneling layer and an upper superconductive layer which are laminated in this order, the present inventors found, as a result of intensive studies, that a bismuth-copper-containing oxide superconductor having a layer-lattice composite perovskite structure may be used as the lower and upper oxide superconductive layers, and a bismuth layer-lattice compound having the similar layer-lattice composite perovskite structure may be used as the tunneling layer, thereby making it possible to prepare a Josephson device with a good crystallizability of superconductive layers and also form a thin and uniform tunneling layer, thus providing a Josephson device having good characteristics.

Further, the use of bismuth-copper containing oxide superconductor has made it possible to provide a Josephson device that can sufficiently operate at temperatures not lower than the liquid nitrogen temperature and is particularly superior in moisture resistance, thermal resistance and so forth.

In the present invention, the bismuth-copper-containing oxide superconductor preferably usable in the lower and upper oxide superconductive layers includes materials represented by the general formula (I):

$$\{(Bi_{1-b}C_b)_2O_2\}(Cu_{1-a}B_a)_{2+n}A_{3+n}O_{(12+3n)-x} \qquad (I)$$

wherein A represents at least one element selected from the elemental group consisting of Group Ia, IIa, IIIa and IVb elements of the periodic table; B represents at least one element selected from the elemental group consisting of Group Ib, IVa, Va, VIa and VIIIa elements; C represents at least one element selected from rare earth elements; and $O \leqq b < 1$, $O \leqq a < 1$, $-1 < n \leqq 10$, and $x > 0$; and having as its crystal structure the layer-lattice structure such that a perovskite-like layer is positioned between $\{(Bi_{1-b}C_b)_2O_2\}^{2+}$ layers $(0 \leqq b < 1)$.

Of the materials represented by the above Formula (I), particularly preferred are those represented by the following formula:

$$Bi_2(Sr,Ca)_3Cu_2O_x \ (7 \leqq x \ 9).$$

The bismuth layer-lattice compound used as the tunneling layer in the present invention preferably includes materials represented by the general formula (II):

$$\{(Bi_{1-b}C_b)_2O_2\}^{2+}\{Bi_{1-a}B_a)_2(Ti_{1-a}A_a)_3O_{10}\}_n^{2-} \qquad (II)$$

wherein C represents at least one element selected from rare earth elements; B represents at least one element selected from the group consisting of Ca, Na, K, Ba, Sr, Pb and Pr; A represents at least one element selected from the group consisting of Nb, Ta, Fe, Sn and Ga; and $O \leqq b < 1$, $O \leqq a < 1$, and $1 \leqq n \leqq 5$; or those represented by the following formula (III):

$$Bi_2Sr_2LnCu_2O_y \qquad (III)$$

wherein Ln represents at least one element selected from the group consisting of Y and lanthanides; and $7 \leqq y \leqq 9$. As the bismuth layer-lattice compound used as the tunneling layer, an insulator compound, a normally conductive compound or a compound having a smaller critical current or a lower critical temperature than that of the above bismuth-copper-containing oxide superconductor is used.

In particular, of the materials represented by the general-formulas (II) and (III);

(II)     - 1) $Bi_4Ti_3O_{12}$
- 2) $Bi_2PbFeTi_{1.5}Sn_{1.5}Oy$ $(7 \leqq y \leqq 9)$
(III)     - 1) $Bi_2Sr_2YCu_2Oy$ $(7 \leqq y \leqq 9)$

are preferably used in the present invention.

The bismuth-copper-containing oxide superconductor and bismuth layer-lattice compound as exemplified above are similar to each other in crystal structure.

More specifically, the bismuth-copper-containing oxide superconductor of the above formula (I), used as the upper and lower superconductive layers in the present invention, is found to be rhombic as a result of X-ray diffraction data, having the lattice constant of a = 5.4 Å, b = 27.0 Å (=5 x a), and c = 30.8 Å. The bismuth layer-lattice compound of the above formula (II) and (III), used as the joining layer, is also found to be rhombic, having the lattice constant of a = 5.5 Å, b = 5.4 Å, and c = 30.2 Å.

When such Josephson device is prepared by using the superconductive layers and the tunneling layer having such crystal structure, there may occur no misfit between the layers because of the similar lattice constants in the both, so that a Josephson device with good characteristics can be obtained. The good characteristics herein mentioned refer to characteristics such as millimeter-wave response and magnetic response. This crystal structure is a layer-lattice composite perovskite structure, so that the film formation can be readily controlled and the uniform and thin layer can be formed as desired.

A good Josephson effect attributable to this crystal structure can be well exhibited when all the upper and lower superconductive layers and the tunneling layer have the similar lattice constants.

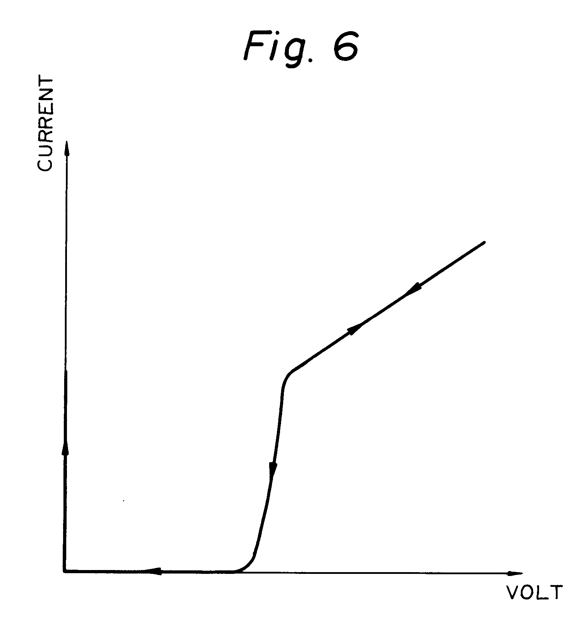

As a result of the measurement of the current-voltage characteristics of the Josephson device constituted according to the present invention, the device shows the characteristics as shown in Fig. 6, from which there is found a superior Josephson effect that the amount of current little changes until the voltage reaches a value higher than a given value and the current abruptly changes when the voltage is decreased to a value lower than a given value.

The Josephson device of the present invention can be prepared according to conventional methods. More specifically, it can be prepared by sputtering or vacuum deposition, which can achieve compositional control, as well as by CVD.

The upper and lower superconductive layers of the Josephson device of the present invention may each preferably have a layer thickness of from 200 nm (2,000 Å) to 500 nm (5,000 Å); and the tunneling layer has a layer thickness of from 1 to 50 nm (10 Å to 500 Å). As the substrate on which these layers are laminated, preferably used are, for example MgO (100) singlecrystals and $SrTiO_3$ singlecrystals.

EXAMPLES

The present invention will now be described below in greater detail by giving Examples.

Example 1

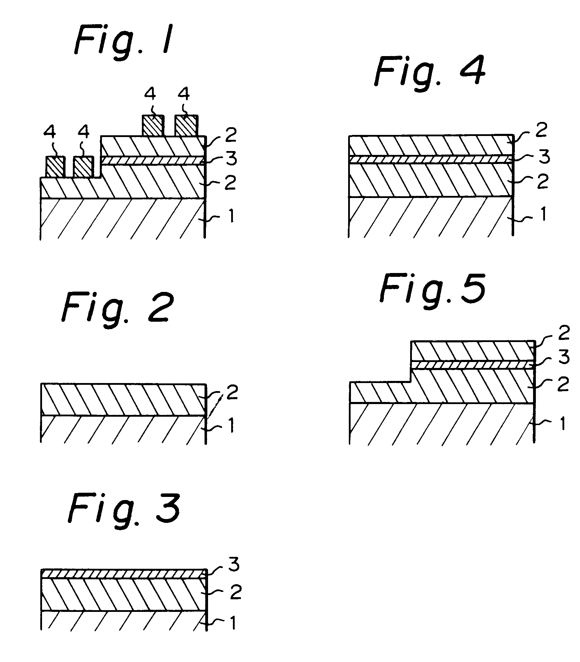

A Josephson junction, as illustrated in Fig. 1, was formed in the following manner. In Fig. 1, the numeral 1 denotes a substrate made of MgO; 2, sputter films comprising a bismuth-copper-containing oxide superconductor; 3, a bismuth layer-lattice compound film; and 4, an electrode.

First, using as a target a sintered material composed of 1 bismuth, 1 strontium, 1 calcium and 2 copper, a superconductive layer 2 was formed with a thickness of 300 nm (3,000 Å) on the MgO substrate 1 according to rapid frequency magnetron sputtering (Fig. 2). The composition of the resulting film was analized according to a plasma emission spectroscopy to reveal that the film was composed of 2 bismuth, 1.48 strontium, 1.50 calcium, and 2.0 copper. The substrate temperature was set at 700°C, and the film formation was carried out in a mixed gas comprising argon and oxygen, at a gas pressure of $6.67 \times 10^{-2}$ mbar ($5 \times 10^{-2}$ Torr) and an oxygen partial pressure of $6,67 \times 10^{-3}$ mbar ($5 \times 10^{-3}$ Torr).

After the above superconductive layer was formed, a heat treatment (under conditions of 840°C and 6 hrs in oxygen 1 atmospheric pressure) was carried out, followed by annealing at a rate of 3°C per minute.

Next, on the resulting bismuth-copper-containing oxide superconductor film 2, the bismuth layer-lattice compound ($Bi_4Ti_3O_{12}$) layer 3 was formed as shown in Fig. 3. The film formation was carried out by ion beam deposition, where $Bi_2O_3$ was used as a starting material containing bismuth atoms and metallic titanium was used as a starting material containing titanium atoms. The substrate temperature was set at 200°C, oxygen gas was fed (9 to 10 mℓ/sec.), and the titanium component was ionized and accelerated at an accelerating voltage of 2 kV and an ionizing current of 100 mA. On the other hand, the vaporized substance generated from the starting material containing bismuth atoms was deposited by resistance heating.

The bismuth and titanium components were deposited at a rate of from 2 to 3 Å/sec., and the resulting $Bi_4Ti_3O_{12}$ thin film 3 had been turned into a layer-lattice film with a thickness of 3 nm (30 Å).

On this film, another bismuth-copper-containing oxide superconductor film 2 was formed by rapid frequency magnetron sputtering (Fig. 4). The film formation rate was set to 5 Å/sec., and the heat treatment as in the first layer film 1 was not carried out. The resulting film 2 had a film thickness of 240 nm (2,400 Å).

Next, a part of the films was removed by argon ion milling to bring them into the state as shown in Fig. 5, followed by vacuum deposition of gold to form the electrode 4, thus forming the device of the present invention, as shown in Fig. 1. The critical temperature of superconductive films of this device was measured to find that it was 105 K.

The current-voltage (I-V) characteristics of this Josephson device was measured at 60 K according to a four-terminal method. As a result, there were obtained the characteristics as shown in Fig. 6, and thus a good junction was seen to have been formed.

Example 2

Example 1 was repeated to form a Josephson device of the present invention, except that the target material used in forming the bismuth-copper-containing oxide superconductor by sputtering was replaced with a material composed of 0.9 bismuth, 0.1 lead, 1 strontium, 1 calcium and 2 copper. After film formation, the composition of the film was analyzed by plasma emission spectroscopy, to find that the film comprised 2 bismuth, 1.0 lead, 3.0 strontium, 2.0 calcium and 5.0 copper in compositional ratio. The resulting device had a critical temperature of 92 K, and the I-V characteristics were measured at 60 K. As a result, there was obtained substantially the same results as Example 1.

Example 3

Example 1 was repeated to form a Josephson device of the present invention, except that the target material used in forming the bismuth-copper-containing oxide superconductor by sputtering was replaced with a material composed of 1 bismuth, 1 strontium, 1 calcium, 1.8 copper and 0.2 titanium. After film formation, the composition of the film was analyzed by plasma emission spectroscopy, to find that the film comprised 1 bismuth, 1.5 strontium, 1.5 calcium, 1.5 copper and 0.5 titanium in compositional ratio. The resulting device had a critical temperature of 60 K.

The I-V characteristics were measured at 20 K to find that there was obtained substantially the same results as Example 1.

Example 4

The bismuth-copper-containing oxide superconductor was formed in the same manner as Example 1, and the material composed of 0.5 sodium, 4.5 bismuth and 4.0 titanium was used as the bismuth layer-lattice compound as an insulating layer. The film formation was carried out in the same manner as Example 1, according to ion beam deposition. Sodium, titanium and $Bi_2O_3$ were used as starting materials. The deposition was carried out under the above compositional ratio while heating the substrate at a temperature of 600°C and feeding oxygen gas at a rate of from 10 to 20 mℓ/min.

The deposition rate was each set to be from 0.5 to 3 Å/sec. and the film had a thickness of 3 nm (30 Å).

Other procedures followed those in Example 1 to form a Josephson device of the present invention. The resulting device showed substantially the same results for both the critical temperature and I-V characteristics.

Example 5

A Josephson junction, as illustrated in Fig. 1, was formed in the following manner. In Fig. 1, the numeral 1 denotes a substrate made of MgO; 2, a lower superconductive layer; 3, an insulating film; 4, an upper superconductive layer; and 5, an electrode.

First, using as a target a sintered material composed of 1 bismuth, 1 strontium, 1 calcium and 2 copper, a bismuth-copper-containing oxide superconductor film was formed on the MgO substrate as a lower superconductive layer with a thickness of 300 nm (3,000 Å) according to rapid frequency magnetron sputtering (Fig. 2). The composition of the resulting film was analized according to plasma emission spectroscopy to reveal that the film had the compositional ratio of $Bi_2Sr_{1.48}Ca_{1.50}Cu_{2.03}O_x$. The substrate was heated to a temperature of 700°C, and the film formation was carried out in a mixed gas comprising Ar and $O_2$, at a gas pressure of $6.67 \times 10^{-2}$ mbar ($5 \times 10^{-2}$ Torr) and an $O_2$ partial pressure of $6.67 \times 10^{-3}$ mbar ($5 \times 10^{-3}$ Torr). After this film was formed, a heat treatment (under conditions of 840°C and 6 hrs in $O_2$ 1 atmospheric pressure) was carried out, followed by annealing at a rate of 3°C per minute.

Next, on the resulting lower superconductive layer, the insulating film ($Bi_2Sr_2YCu_2O_y$) was formed as shown in Fig. 3. The film formation was carried out by ion beam deposition, where $Bi_2O_3$ and SrO were used as starting materials containing Bi and Sr atoms, and Y and Cu were used as starting materials containing Y and Cu atoms. The substrate was heated to a temperature of 200°C, oxygen gas was fed (9 to 10 mℓ/sec.), and the Y and Cu components were ionized and accelerated at an accelerating voltage of 2 kV and an ionizing current of 100 mA. On the other hand, the vaporized substances generated from the starting materials containing Bi and Sr atoms was deposited by resistance heating. The deposition was carried out at a rate of from 1 to 2 Å/sec., and the resulting $Bi_2Sr_2YCu_2O_y$ thin film had a thickness of 3 nm (30 Å).

On this film, another bismuth-copper-containing oxide superconductor film was formed as an upper superconductive layer by rapid frequency magnetron sputtering (Fig. 4). The film formation rate was set at 5 Å/sec., and the heat treatment as in the lower superconductive layer film 1 was not carried out. The resulting film 2 had a thickness of 240 nm (2,400 Å).

Next, a part of the films was removed by Ar ion milling to bring them into the state as shown in Fig. 5, followed by vacuum deposition of Au to form the electrode, thus forming the junction as shown in Fig. 1. The critical temperature of this device was measured to find that it was 80 K.

The current-voltage characteristics of this Josephson junction was measured at 60 K according to a four-terminal method. As a result, there were obtained the characteristics as shown in Fig. 6, and thus a good junction was seen to have been formed.

Example 6

The bismuth-copper-containing oxide superconductor was formed in the same manner as Example 1, and the material composed of 2 bismuth, 1 lead, 1 iron, 1.5 titanium, 1.5 tin and 7 oxygen was used as the bismuth layer-lattice compound as an insulating layer. The film formation was carried out in the same manner as Example 1, according to ion beam deposition. Lead, iron, titanium, tin and $Bi_2O_3$ were used as starting materials. The deposition was carried out under the above compositional ratio while heating the substrate at a temperature of 600°C and feeding oxygen gas at a rate of from 10 to 20 mℓ/min.

The deposition rate was each set to be from 0.5 to 3 Å/sec. and the film had a thickness of 3 nm (30 Å).

Other procedures followed those in Example 1 to form a Josephson device of the present invention. The resulting device showed substantially the same results for both the critical temperature and I-V characteristics.

## Claims

1. A Josephson device, comprising a substrate, a lower superconductive layer, a tunneling layer and an upper superconductive layer which are laminated in this order, characterised in that said lower and upper superconductive layers each comprise a bismuth-copper-oxide superconductor having a layered perovskite structure and said tuneling layer comprises a bismuth oxide compound having a similar layered perovskite structure, the lattice constant of the lower superconductive layer, the upper superconductive layer and the tunneling layer being similar so that no misfit occurs when growing one layer on top of the other.

2. A Josephson device according to claim 1, wherein said lower and upper superconductive layers each comprise a bismuth-copper-containing oxide superconductor represented by the formula:

$$\{(Bi_{1-b}C_b)_2O_2\} (Cu_{1-a}B_a)_{2+n}A_{3+n}O(12+3n)-x$$

wherein:

A represents at least one element selected from the elemental group consisting of Group Ia, IIa, IIIa and IVb elements of the periodic table;

B represents at least one element selected from the elemental group consisting of Group Ib, IVa, Va, VIa and VIIIa elements;

C represents at least one element selected from rare earth elements; and

$0 \leqq b < 1$,

$0 \leqq a < 1$,

$-1 < n \leqq 10$, and

$x > 0$; and

said tunneling layer comprises a bismuth-containing oxide represented by the formula:

$$\{(Bi_{1-b}C_b)_2O_2\}^{2+}\{Bi_{1-a}B_a)_2(Ti_{1-a}A_a)_3O_{10}\}^{2-}{}_n$$

wherein:

C represents at least one element selected from rare earth elements;

B represents at least one element selected from the group consisting of Ca, Na, K, Ba, Sr, Pb and Pr;

A represents at least one element selected from the group consisting of Nb, Ta, Fe, Sn and Ga; and

$0 \leqq b < 1$,

$0 \leqq a < 1$, and

$1 \leqq n \leqq 5$.

3. The Josephson device according to claim 1, wherein said bismuth-copper-containing oxide superconductor has a layer-lattice structure such that a perovskite-like layer is positioned between $\{(Bi_{1-b}C_b)_2O_2\}^{2+}$ layers.

4. The Josephson device according to claim 1, 2 or 3, wherein said bismuth-copper-containing oxide superconductor comprises a superconductor constituted of elements comprising Bi, Sr, Ca, Cu and O.

5. A Josephson device according to any preceding claim, wherein the tunneling layer comprises a bismuth-containing oxide represented by the formula:

$$Bi_2Sr_2LnCu_2O_Y$$

wherein Ln represents at least one element selected from the group consisting of Y and lanthanides; and $7 \leqq y \leqq 9$.

6. The Josephson device according to any preceding claim, wherein said bismuth-containing oxide is selected from an insulator compound, a normally conductive compound, a compound having a smaller critical current than that of said bismuth-copper-containing oxide superconductor and a compound having a lower critical temperature than that of said bismuth-copper-containing oxide superconductor.

7. The Josephson device according to any preceding claim, wherein said lower and upper superconductive layers each have a layer thickness of from 200 nm to 500 nm (2,000 Å to 5000 Å).

8. The Josephson device according to any preceding claim, wherein said tunneling layer has a layer thickness of from 1 nm to 50 nm (10 Å to 500 Å).

9. The Josephson device according to any preceding claim, wherein the substrate is a MgO(100) single crystal or a SrTiO$_3$ single crystal.

## Patentansprüche

1. Josephson-Vorrichtung, umfassend ein Substrat, eine untere Supraleiter-Schicht, eine Tunnelschicht und eine obere Supraleiter-Schicht, die in dieser Reihenfolge laminiert sind, dadurch gekennzeichnet, daß die untere und die obere Supraleiter-Schicht jeweils einen Wismut-Kupfer-Oxid-Supraleiter mit einer Perowskit-Schichtstruktur umfassen und die Tunnelschicht eine Wismutoxid-Verbindung mit einer ähnlichen Perowskit-Schichtstruktur umfaßt, wobei die Gitterkonstante der unteren Supraleiterschicht, der oberen Supraleiterschicht und der Tunnelschicht ähnlich ist, so daß keine Fehlanpassung auftritt, wenn eine Schicht über die andere gewachsen wird.

2. Josephson-Vorrichtung nach Anspruch 1, wobei die untere und obere Supraleiter-Schicht jeweils einen Wismut-Kupferenthaltenden Oxid-Supraleiter umfassen, der durch die folgende Formel dargestellt wird:

$$\{(Bi_{1-b}C_b)_2O_2\}\,(Cu_{1-a}B_a)_{2+n}A_{3+n}O(12+3n)\text{-}x$$

worin:

A mindestens ein Element darstellt, das aus der Elementgruppe ausgewählt ist, die aus den Elementen der Gruppe Ia, IIa, IIIa und IVb des Periodensystems besteht;

B mindestens ein Element darstellt, das aus der Elementgruppe ausgewählt ist, die aus den Elementen der Gruppe Ib, IVa, Va, VIa und VIIIa besteht;

C mindestens ein Element darstellt, das aus den Seltenerdelementen ausgewählt ist; und

$0 \leqq b < 1$,

$0 \leqq a < 1$,

$-1 < n \leqq 10$, und

$x > 0$; und

die Tunnelschicht ein Wismut-enthaltendes Oxid umfaßt, das durch die folgende Formel dargestellt wird:

$$\{(Bi_{1-b}C_b)_2O_2\}^{2+}\{Bi_{1-a}B_a)_2(Ti_{1-a}A_a)_3O_{10}\}^{2-}{}_n,$$

worin:

C mindestens ein Element darstellt, das aus den Seltenerdelementen ausgewählt ist;

B mindestens ein Element darstellt, das aus der Gruppe ausgewählt ist, die aus Ca, Na, K, Ba, Sr, Pb und Pr besteht;

A mindestens ein Element darstellt, das aus der Gruppe ausgewählt ist, die aus Nb, Ta, Fe, Sn und Ga besteht; und

$0 \leqq b < 1$,

$0 \leqq a < 1$, und

$1 \leqq n \leqq 5$.

3. Josephson-Vorrichtung nach Anspruch 1, wobei der Wismut-Kupfer-enthaltende Oxid-Supraleiter eine Schicht-Gitterstruktur hat, so daß sich eine Perowskit-ähnliche Schicht zwischen $\{(Bi_{1-b}C_b)_2O_2\}^{2+}$-Schichten befindet.

4. Josephson-Vorrichtung nach einem der Ansprüche 1, 2 oder 3, wobei der Wismut-Kupfer-enthaltende Oxid-Supraleiter einen Supraleiter umfaßt, der aus Elementen, umfassend Bi, Sr, Ca, Cu und O aufgebaut ist.

5. Josephson-Vorrichtung nach einem der vorhergehenden Ansprüche, wobei die Tunnelschicht ein Wismut-enthaltendes Oxid umfaßt, das durch die folgende Formel dargestellt wird:

$$Bi_2Sr_2LnCu_2O_y$$

worin Ln mindestens ein Element darstellt, das aus der Gruppe, bestehend aus Y und Lanthaniden ausgewählt ist; und $7 \leqq y \leqq 9$.

6. Josephson-Vorrichtung nach einem der vorhergehenden Ansprüche, wobei das Wismut-enthaltende Oxid aus einer Isolatorverbindung, einer normalleitenden Verbindung, einer Verbindung mit einem kleinerem kritischen Strom als bei dem Wismut-Kupfer-enthaltenden Oxid-Supraleiter und einer Verbindung mit einer niedrigeren kritischen Temperatur als der des Wismut-Kupfer-enthaltenden Oxid-Supraleiters ausgewählt ist.

7. Josephson-Vorrichtung nach einem der vorhergehenden Ansprüche, wobei die untere und obere Supraleiterschicht jeweils eine Schichtdicke von 200 nm bis 500 nm (2000 Å bis 5000 Å) haben.

8. Josephson-Vorrichtung nach einem der vorhergehenden Ansprüche, wobei die Tunnelschicht eine Schichtdicke von 1 nm bis 50 nm (10 Å bis 500 Å) hat.

9. Josephson-Vorrichtung nach einem der vorhergehenden Ansprüche, wobei das Substrat ein MgO(100)-Einkristall oder ein SrTiO₃-Einkristall ist.

**Revendications**

1. Dispositif Josephson comportant un substrat, une couche supraconductrice inférieure, une couche à effet tunnel et une couche supraconductrice supérieure qui sont stratifiées dans cet ordre, caractérisé en ce que lesdites couches supraconductrices inférieure et supérieure comprennent chacune un supraconducteur à oxyde-bismuth-cuivre ayant une structure en perovskite stratifiée et ladite couche à effet tunnel comprend un composé d'oxyde de bismuth ayant une structure en perovskite multicouche similaire, la constante de réseau de la couche supraconductrice inférieure, de la couche supraconductrice supérieure et de la couche à effet tunnel étant similaire afin qu'aucun défaut d'adaptation n'apparaisse lors de la croissance d'une couche sur le dessus de l'autre.

2. Dispositif Josephson selon la revendication 1, dans lequel lesdites couches supraconductrices inférieure et supérieure comprennent chacun un supraconducteur à oxyde contenant du bismuth et du cuivre, représenté par la formule :

$$\{(Bi_{1-b}C_b)_2O_2\}\,(Cu_{1-a}B_a)_{2+n}A_{3+n}O(12+3n)\text{-}x$$

dans laquelle :

A représente au moins un élément choisi dans le groupe élémentaire constitué d'éléments des Groupes Ia, IIa, IIIa et IVb du Tableau Périodique ;

B représente au moins un élément choisi dans le groupe élémentaire constitué d'éléments des Groupes Ib, IVa, Va, VIa et VIIIa ;

C représente au moins un élément choisi parmi des éléments des terres rares ; et

$0 \leqq b < 1$,

$0 \leqq a < 1$,

$-1 < n \leqq 10$ et

$x > 0$ ; et

ladite couche à effet tunnel comprend un oxyde contenant du bismuth représenté par la formule :

$$\{(Bi_{1-b}C_b)_2O_2\}^{2+}\{Bi_{1-a}B_a)_2(Ti_{1-a}A_a)_3O_{10}\}^{2-}_n$$

dans laquelle :

C représente au moins un élément choisi parmi des éléments des terres rares ;

B représente au moins un élément choisi dans le groupe constitué de Ca, Na, K, Ba, Sr, Pb et Pr ;

A représente au moins un élément choisi dans le groupe constitué de Nb, Ta, Fe, Sn et Ga ; et

$0 \leqq b < 1$,

$0 \leqq a < 1$, et

$1 \leqq n \leqq 5$.

3. Dispositif Josephson selon la revendication 1, dans lequel ledit supraconducteur à oxyde contenant du bismuth et du cuivre possède une structure en couche-réseau telle qu'une couche analogue à de la perovskite est positionnée entre les couches de $\{(Bi_{1-b}C_b)_2O_2\}^{2+}$.

4. Dispositif Josephson selon la revendication 1, 2 ou 3, dans lequel ledit supraconducteur en oxyde contenant du bismuth et du cuivre comprend un supraconducteur constitué des éléments comprenant Bi, Sr, Ca, Cu et O.

5. Dispositif Josephson selon l'une quelconque des revendications précédentes, dans lequel la couche à effet tunnel comprend un oxyde contenant du bismuth représenté par la formule :

$$Bi_2Sr_2LnCu_2O_y$$

dans laquelle Ln représente au moins un élément choisi dans le groupe constitué de Y et de lanthanides et $7 \leqq y \leqq 9$.

6. Dispositif Josephson selon l'une quelconque des revendications précédentes, dans lequel ledit oxyde contenant du bismuth est choisi parmi un composé isolant, un composé normalement conducteur, un composé ayant un courant critique inférieur à celui dudit supraconducteur en oxyde contenant du bismuth et du cuivre et un composé ayant une température critique inférieure à celle dudit supraconducteur en oxyde contenant du bismuth et du cuivre.

7. Dispositif Josephson selon l'une quelconque des revendications précédentes, dans lequel lesdites couches supraconductrices inférieure et supérieure ont chacune une épaisseur de 200 nm à 500 nm (2000 Å à 5000 Å).

8. Dispositif Josephson selon l'une quelconque des revendications précédentes, dans lequel ladite couche à effet tunnel a une épaisseur de 1 nm à 50 nm (10 Å à 500 Å).

9. Dispositif Josephson selon l'une quelconque des revendications précédentes, dans lequel le substrat est un monocristal de MgO(100) ou un monocristal de SrTiO₃.

Fig. 1

Fig. 4

Fig. 2

Fig. 5

Fig. 3

# Fig. 6